# EUROPÄISCHE PATENTANMELDUNG

(11) **EP 1 903 672 A2**
(43) Veröffentlichungstag der Anmeldung: **26.03.2008**
(21) Anmeldenummer: 07016969.3
(22) Anmeldetag: 30.08.2007
(51) Int. Cl.: H03F 1/48, H03F 3/187, H03F 3/45

(54) **Dreistufiger Verstärker**

(30) Priorität: 20.09.2006 DE 102006044732
(71) Anmelder: Micronas GmbH, 79108 Freiburg (DE)
(72) Erfinder: Theus, Ulrich, 79194 Gundelfingen (DE); Kessel, Jürgen, 79102 Freiburg (DE)
(74) Vertreter: Patentanwälte Westphal, Mussgnug & Partner

(57) **Zusammenfassung**

Die Erfindung betrifft eine Verstärkerschaltung mit Offset-Reduktion und ausreichend hoher Bandbreite mit zwei an Eingangsklemmen (1,2) parallel geschalteten Eingangsstufen (3,4) eines ersten Verstärkers (A), wobei die erste Eingangsstufe (3) mit den Eingangsklemmen direkt und die zweite Eingangsstufe (4) über einen zweiten Verstärker (B) angeschlossen ist, und wobei an den Ausgang des ersten Verstärkers (A) ein dritter Verstärker (C) geschaltet ist, wobei der zweite Verstärker (B) eine symmetrische Last aufweist.

## Beschreibung

Die Erfindung betrifft eine dreistufige Verstärkerschaltung mit Offset-Reduktion und ausreichend hoher Bandbreite für die Anwendung im Audiofrequenzbereich.

Nutzbare Bandbreite, Gleichspannungsverstärkung, Offset und Rauschen stellen die wesentlichen und oft den Einsatzbereich begrenzenden Leistungsparameter bei der Anwendung von Operationsverstärkern dar. Dabei weisen beispielsweise in CMOS-Technologie realisierte Verstärker geringe Ruheströme auf, demgegenüber aber relativ große Offset-Spannungen und relativ hohes Rauschen. Dennoch wird die CMOS-Technologie bei der Miniaturisierung integrierte Schaltungen bevorzugt, da sie im Vergleich zu anderen Technologien geringe Verlustleistung und damit geringe Wärmeentwicklung auch bei hoher Packungsdichte in integrierten Schaltungen aufweist.

Typische, in CMOS-Technologie ausgeführte integrierte Verstärkerschaltungen nach dem Stand der Technik sind beispielsweise als zweistufige Verstärkerschaltungen ausgeführt. Eine solche Verstärkerschaltung mit ausreichend hoher Bandbreite und ausreichend geringem Rauschen ist beispielsweise aus EP 0460 263 B1 bekannt.

Symmetrische Verstärkerschaltungen sind aus dem Stand der Technik bekannt. Prinzipiell werden hierfür als Lastelemente zwei Stromquellen mit Gleichtaktregler eingesetzt. Solche bekannten Verstärkerschaltungen weisen eine niedrige Impedanz für Gleichtaktansteuerung und eine hohe Impedanz für Gegentaktansteuerung auf. Es ist deshalb bei diesen bekannten Schaltungen eine Gleichtaktregelung erforderlich.

Die zunehmende Miniaturisierung integrierter Verstärkerschaltungen in CMOS-Technologie, auch in Verbindung mit komplexeren Gesamtlösungen in einer einzelnen integrierten Schaltungsanordnung, führt jedoch zu einer weiteren Verringerung der räumlichen Ausdehnung der dabei realisierten CMOS-Strukturen, typischerweise im Bereich von 0,35 µm und darunter. Die Abkürzung CMOS bezeichnet dabei Complementary Metal Oxide Semicon-, ductor, also Halbleiterstrukturen, die in integrierten Schaltkreisen Anwendung finden und gleichzeitig p-Kanal wie auch n-Kanal-MOSFETS (Metal Oxide Semiconductor Field Effect Transistoren) umfassen, die auch als PMOS- und NMOS-Transistoren bezeichnet werden.

Nachteilig wirkt sich dabei aus, dass die mit oben genannten CMOS-Prozessen von 0,35 µm und darunter realisierten PMOS-Transistoren der CMOS-Strukturen erhöhtes 1/f-Rauschen aufweisen, wenn sie so dimensioniert werden, dass sie die geforderte Bandbreite der Verstärkerschaltung sicher stellen, wodurch eine Anwendung in Verstärkerschaltungen nach dem Stand der Technik zu hohes Rauschen, beispielsweise für den Einsatz als Verstärkerschaltung im Audiofrequenzbereich zur Folge hat.

Aufgabe der vorliegenden Erfindung ist es, eine in CMOS-Technologie als integrierten Schaltkreis realisierte Verstärkerschaltungsanordnung mit Offset-Reduktion zur Verfügung zu stellen, welche eine beispielsweise für Audioanwendungen ausreichende Bandbreite und weiterhin ein beispielsweise für Audioanwendungen ausreichend geringes Rauschen bereitstellt.

Die Aufgabe wird gelöst durch einen Verstärker mit den Merkmalen des Anspruchs 1.

Erfindungsgemäß wird demnach zusätzlich in den Halbleiterkörper einer Verstärkerschaltungsanordnung nach dem Stand der Technik ein weiterer Verstärker für die Offset-Reduktion integriert, wobei der Ausgang dieses weiteren Verstärkers über eine Last mit einer Eingangsstufe des ersten Verstärkers der zweistufigen Verstärkerschaltungsanordnung nach dem Stand der Technik verbunden ist und dieser weitere Verstärker an seinem Ausgang mit einer symmetrischen Last aus zwei über Kreuz parallel geschalteten Stromspiegeln beaufschlagt wird, und wodurch sich eine dreistufige Verstärkerschaltung ergibt.

Die vorteilhafte Wirkung der Erfindung ergibt sich aus der Ergänzung der zweistufigen, zwei Verstärkerschaltungsanordnungen umfassenden Verstärkerschaltung nach dem Stand der Technik um eine weitere, nachfolgend als zweiten Verstärker oder zweite Verstärkungsstufe bezeichnete Verstärkerschaltungsanordnung, was der Trennung des ersten Verstärkers der zweistufigen Verstärkerschaltung nach dem Stand der Technik in jeweils eine erste Verstärkerschaltungsanordnung (nachfolgend auch als erster Verstärker bezeichnet) und eine zweite Verstärkerschaltungsanordnung entspricht, die auf diese Weise unabhängig voneinander optimiert werden können. Dabei erhält die erste Verstärkerstufe zwei parallel geschaltete Eingangsstufen, wobei eine Eingangsstufe mit den Eingangsklemmen der Verstärkerschaltung direkt verbunden ist und die andere Eingangsstufe über einen Verstärker an diese Eingangsklemmen angeschlossen ist.

Weitere Vorteile können sich auch daraus ergeben, wenn die zweite Verstärkerschaltungsanordnung beziehungsweise Verstärkerstufe der Verstärkerschaltung ausgelegt wird, um insgesamt ausreichend niedriges Rauschen der Verstärkerschaltung für Audioanwendungen zu erzielen und die erste Verstärkerschaltungsanordnung beziehungsweise Verstärkerstufe der Verstärkerschaltung ausgelegt wird, um einen kompensierbaren Frequenzgang zur Erzielung der gewünschten Bandbreite der Verstärkerschaltung für Audioanwendungen zur Verfügung zu stellen.

Noch weitere Vorteile können sich auch daraus ergeben, wenn die große Eingangskapazität der symmetrischen, zwei über Kreuz parallel geschaltete Stromspiegel aufweisende Last der zweiten Verstärkerschaltungsanordnung eine Tiefpassfunktion dergestalt aufweist, dass in der ersten Verstärkerschaltungsanordnung nur noch eine Feinabstimmung des Gesamtfrequenzgangs der Verstärkerschaltung und damit der Bandbreite durchgeführt werden muss.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt
- Fig. 1: das Blockschaltbild der dreistufigen Verstärkerschaltung,
- Fig. 2: die Detailansicht der Schaltungsanordnung der dreistufigen Verstärkerschaltung.

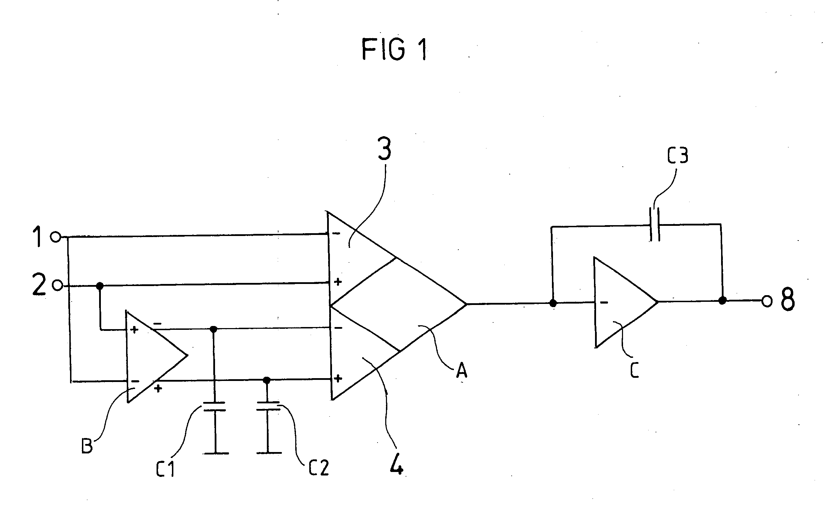

Die erfindungsgemäße Schaltungsanordnung nach Fig.1 zeigt ein Blockschaltbild der erfindungsgemäßen, dreistufigen Verstärkerschaltung und umfasst eine erste Eingangsklemme 1 und eine zweite Eingangsklemme 2 sowie einen ersten, als differentiellen Differenzverstärker (differential difference amplifier) ausgeführten Verstärker A, einen zweiten Verstärker B und einen dritten Verstärker C. Weiterhin umfasst die Schaltungsanordnung nach Fig.1 eine erste, als Differenzverstärker ausgeführte Eingangsstufe 3 und eine zweite, als Differenzverstärker ausgeführte Eingangsstufe 4, die durch Parallelschaltung den ersten Verstärker A bilden, sowie eine erste Kapazität C1, eine zweite Kapazität C2, eine dritte Kapazität C3 und eine Ausgangsklemme 8.

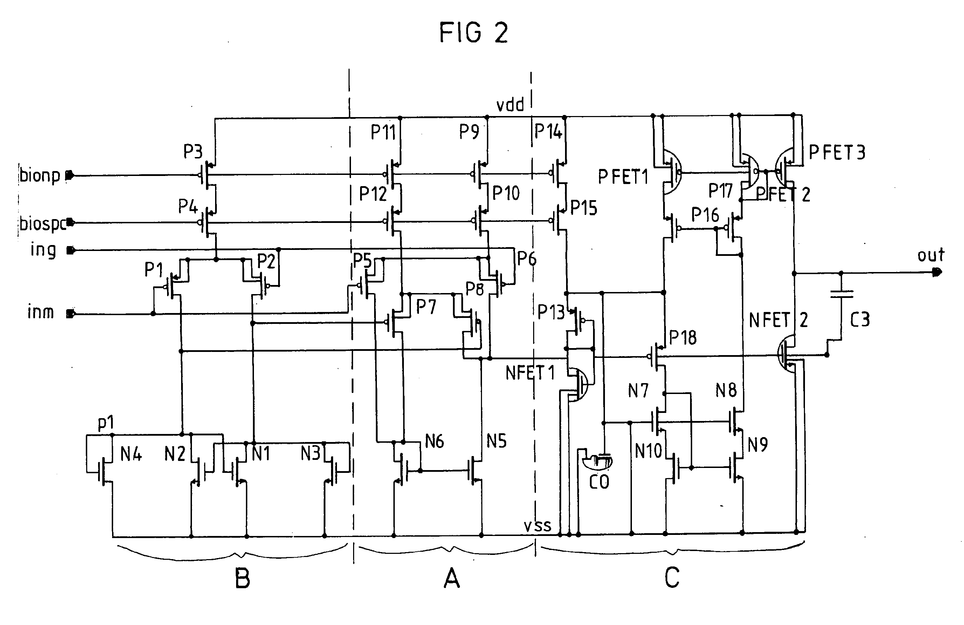

Gemäß Fig.1 ist die erste Eingangsklemme 1 direkt verbunden mit dem invertierenden Eingang der ersten Eingangsstufe 3 des ersten Verstärkers A und die zweite Eingangsklemme 2 ist direkt verbunden mit dem nichtinvertierenden Eingang der ersten Eingangsstufe 3 des ersten Verstärkers A. Weiterhin ist die erste Eingangsklemme 1 direkt verbunden mit dem invertierenden Eingang des zweiten Verstärkers B und die zweite Eingangsklemme 2 ist direkt verbunden mit dem nicht invertierenden Eingang des zweiten Verstärkers B. Die Ausgänge des als symmetrischen Differenzverstärker ausgeführten Verstärker B sind verbunden mit einer symmetrischen kapazitiven Last, die in Fig.2 genauer ausgeführt wird und in Fig.1 durch die erste Kapazität C1 und die zweite Kapazität C2 bezeichnet ist.

Weiterhin sind der Plus- und der Minus-Ausgang des zweiten, als Differenzverstärker ausgeführten Verstärkers B völlig symmetrisch verbunden mit dem invertierenden und nicht invertierenden Eingang der zweiten, als Differenzverstärker ausgeführten Eingangsstufe 4 des ersten Verstärkers A. Der aus der Parallelschaltung der Ausgänge der ersten Eingangsstufe 3 und der zweiten Eingangsstufe 4 gebildete Ausgang des ersten Verstärkers A ist verbunden mit dem invertierenden Eingang des dritten Verstärkers C, wobei die dritte Kapazität C3 als Kompensationskapazität mit ihrer einen Klemme mit dem invertierenden Eingang des dritten Verstärkers C verbunden ist und mit ihrer anderen Klemme mit dem Ausgang des dritten Verstärkers C und damit mit der Ausgangsklemme 8 verbunden ist.

Auf diese Weise stellt das Blockschaltbild gemäß Fig.1 die Erweiterung der nach dem Stand der Technik aus EP 0460 263 B1 bekannten zweistufigen Verstärkerschaltung dar, wobei die dritte Verstärkungsstufe C gemäß Fig.1 identisch ist der bekannten Ausführung der zweiten Verstärkerstufe der zweistufigen Verstärkerschaltung nach dem Stand der Technik. Gegenüber dem Stand der Technik ist die erste Verstärkerstufe A ergänzt um eine zweite als Differenzverstärker mit beispielsweise kleinerer Steilheit im Vergleich zur ersten Eingangsstufe 3 ausgeführte Eingangsstufe 4, die mit den Ausgängen der gegenüber dem Stand der Technik zusätzlichen neuen, zweiten Verstärkerstufe B verbunden ist.

Dabei weist die CMOS-Struktur der zweiten Verstärkerstufe B PMOS- und NMOS-Transistorstrukturen auf, die, um für Audioanwendungen ausreichend geringes 1/f-Rauschen zu erzielen, so ausgeführt sind, dass dadurch zusätzliche unerwünschte Phasendrehungen in Frequenzbereichen entstehen, die unerwünschte Einflüsse auf die Stabilität der Gesamtschaltung haben kann. Die erfindungsgemäße Ausführungsform der zweiten Verstärkerstufe B mit den Kapazitäten C1 und C2 weist geringe Transitfrequenzen von ca. 1 MHz auf. Die wirksame Bandbreite der zweiten Verstärkerstufe B muss daher so eingestellt werden, dass diese unerwünschten Phasendrehungen keinen Einfluss auf den erwünschten Gesamtfrequenzgang der Verstärkerschaltung haben.

Dies wird erfindungsgemäß dadurch erreicht, dass die zweite Verstärkerstufe B nicht mit einem einfachen Stromspiegel als Last betrieben wird, sondern mit einer symmetrischen Last bestehend aus zwei über Kreuz parallel geschalteten Stromspiegeln, wobei die zweite Verstärkerstufe B und die Ankopplung der zweiten Verstärkerstufe B an die erste Verstärkerstufe A vorzugsweise völlig symmetrisch ausgeführt sind.

Dabei bewirkt die hohe Eingangskapazität der zwei über Kreuz parallel geschalteten Stromspiegel ohne zusätzliche Vorrichtungen bereits eine erwünschte Tiefpassfilterung des Ausgangssignals der zweiten Verstärkerstufe B. Eine Feinabstimmung des erwünschten Frequenzganges wird weiterhin über die Einstellung der relativen Größen der Steilheiten der jeweils als Differenzverstärker ausgeführten ersten Eingangsstufe 3 und zweiten Eingangsstufe 4 der ersten Verstärkerstufe A erreicht. Fig.2 zeigt die Detailansicht der erfindungsgemäßen Schaltungsanordnung gemäß obiger Beschreibung.

Die erfindungsgemäße Schaltungsanordnung nach Fig.2 umfasst eine erste p-Kanal MOS-Transistorstruktur P1 und eine zweite p-Kanal MOS-Transistorstruktur P2, die zusammen die Differenzverstärkerstruktur der zweiten Verstärkerstufe B bilden. Weiterhin umfasst Fig.2 eine dritte p-Kanal MOS-Transistorstruktur P3 und eine vierte p-Kanal CMOS-Transistorstruktur P4, die die Stromquelle für die aus der ersten p-Kanal MOS-Transistorstruktur P1 und der zweiten p-Kanal MOS-Transistorstruktur P2 gebildete Differenzverstärkerstruktur bilden.

Fig.2 umfasst weiterhin eine erste n-Kanal MOS-Transistorstruktur N1, eine zweite n-Kanal MOS-Transistorstruktur N2, eine dritte n-Kanal MOS-Transistorstruktur N3 und eine vierte n-Kanal MOS-Transistorstruktur N4, wobei die erste n-Kanal MOS-Transistorstruktur N1 und die vierte n-Kanal MOSTransistorstruktur N4 einen Stromspiegel bilden und die zweite n-Kanal MOS-Transistorstruktur N2 und die dritte n-Kanal MOS-Transistorstruktur N3 einen Stromspiegel bilden.

Weiterhin umfasst Fig.2 eine fünfte p-Kanal MOS-Transistorstruktur P5 und eine sechste p-Kanal MOS-Transistorstruktur P6, die zusammen die Differenzverstärkerstruktur der ersten Eingangsstufe 3 der ersten Verstärkerstufe A bilden sowie eine siebte p-Kanal MOS-Transistorstruktur P7 und eine achte p-Kanal MOS-Transistorstruktur P8, die zusammen die Differenzverstärkerstruktur der zweiten Eingangsstufe 4 der ersten Verstärkerstufe A bilden. Fig. 2 umfasst weiterhin ebenfalls eine neunte p-Kanal MOS-Transistorstruktur P9 und eine zehnte p-Kanal MOS-Transistorstruktur P10, die die Stromquelle für die aus der fünften p-Kanal MOS-Transistorstruktur P5 und der sechsten p-Kanal MOS-Transistorstruktur P6 gebildete Differenzverstärkerstruktur der ersten Eingangsstufe 3 der ersten Verstärkerstufe A bilden.

Weiterhin umfasst Fig.2 eine elfte p-Kanal MOS-Transistorstruktur-P11 und eine zwölfte p-Kanal MOS-Transistorstruktur P12, die die Stromquelle für die aus der siebten p-Kanal MOS-Transistorstruktur P7 und der achten p-Kanal MOS-Transistorstruktur P8 gebildete Differenzverstärkerstruktur der zweiten Eingangsstufe 4 der ersten Verstärkerstufe A bilden. Fig.2 umfasst weiterhin eine fünfte n-Kanal MOS-Transistorstruktur N5 und eine sechste n-Kanal MOS-Transistorstruktur N6, die einen als Last für die erste Verstärkerstufe A dienenden Stromspiegel bilden.

Fig.2 umfasst des Weiteren eine dreizehnte p-Kanal MOS-Transistorstruktur P13 und eine erste n-Kanal FET-Transistorstruktur NFET1, die Bestandteil des dritten Verstärkers C bilden. Weiterhin umfasst Fig.2 eine vierzehnte p-Kanal MOS-Transistorstruktur P14 und eine fünfzehnte p-Kanal MOS-Transistorstruktur P15, die die Stromquelle für die aus der dreizehnten p-Kanal MOS-Transistorstruktur P13 und der ersten n-Kanal FET-Transistorstruktur NFET1 gebildete Kette von MOS-Dioden bilden.

Weiterhin umfasst die erfindungsgemäße Schaltungsanordnung gemäß Fig. 2 die nach dem Stand der Technik bekannten Komponenten in der dritten Verstärkerstufe C. Diese sind eine sechzehnte p-Kanal CMOS-Transistorstruktur P16, eine siebzehnte p-Kanal CMOS-Transistorstruktur P17 und eine achtzehnte p-Kanal CMOS-Transistorstruktur P18 sowie eine siebte n-Kanal CMOS-Transistorstruktur N7, eine achte n-Kanal CMOS-Transistorstruktur N8, eine neunte n-Kanal CMOS-Transistorstruktur N9 und eine zehnte n-Kanal CMOS-Transistorstruktur N10.

Fig. 2 umfasst schließlich die erste p-Kanal FET-Transistorstruktur PFET1, die zweite p-Kanal FET-Transistorstruktur PFET2, die dritte p-Kanal FET-Transistorstruktur PFET3, die zweite n-Kanal FET-Transistorstruktur NFET2 und die eine erste und eine zweite Anschlussklemme aufweisende Kapazität C0 sowie eine der ersten Eingangsklemme 1 gemäß Fig.1 entsprechende erste Eingangsklemme inp, eine der zweiten Eingangsklemme 2 gemäß Fig.1 entsprechende zweite Eingangsklemme inm, eine dritte Eingangsklemme biasp und eine vierte Eingangsklemme biasp.

Gemäß Fig.2 ist die erste Eingangsklemme inp verbunden mit dem Gate-Anschluss der zweiten p-Kanal CMOS-Transistorstruktur P2 und dem Gate-Anschluss der sechsten p-Kanal CMOS-Transistorstruktur P6. Weiterhin ist die zweite Eingangsklemme inm verbunden mit dem Gate-Anschluss der ersten p-Kanal CMOS-Transistorstruktur P1 und dem Gate-Anschluss der fünften p-Kanal MOS-Transistorstruktur P5. Die dritte, mit einer passenden Vorspannung beaufschlagte Eingangsklemme binsp ist verbunden mit dem Gate-Anschluss der dritten p-Kanal MOS-Transistorstruktur P3, dem Gate-Anschluss der elften p-Kanal CMOS-Transistorstruktur P11, dem Gate-Anschluss der neunten p-Kanal CMOS-Transistorstruktur P9 und dem Gate-Anschluss der vierzehnten p-Kanal CMOS-Transistorstruktur P14. Die vierte, mit einer passenden Vorspannung beaufschlagte Eingangsklemme biaspc ist verbunden mit dem Gate-Anschluss der vierten p-Kanal CMOS-Transistorstruktur P4, dem Gate-Anschluss der zwölften p-Kanal CMOS-Transistorstruktur P12, dem Gate-Anschluss der zehnten p-Kanal CMOS-Transistorstruktur P10 und dem Gate-Anschluss der fünfzehnten p-Kanal CMOS-Transistorstruktur P15.

Weiterhin sind gemäß Fig.2 untereinander verbunden die Source-Anschlüsse der dritten p-Kanal CMOS-Transistorstruktur P3, der elften p-Kanal CMOS-Transistorstruktur P11, der neunten p-Kanal CMOS-Transistorstruktur P9 der vierzehnten p-Kanal CMOS-Transistorstruktur P14, der ersten p-Kanal FET-Transistorstruktur PFET1, der zweiten p-Kanal FET-Transistorstruktur PFET2, der dritten p-Kanal FET-Transistorstruktur PFET3, wobei diese Verbindung das Potential der oberen Betriebsspannung vdd aufweist. Weiterhin ist dabei verbunden der Drain-Anschluss der dritten p-Kanal CMOS-Transistorstruktur P3 mit dem Source-Anschluss der vierten p-Kanal CMOS-Transistorstruktur P4, der Drain-Anschluss der elften p-Kanal CMOS-Transistorstruktur P11 ist verbunden mit dem Source-Anschluss der zwölften p-Kanal CMOS-Transistorstruktur P12, der Drain-Anschluss der neunten p-Kanal CMOS-Transistorstruktur P9 ist verbunden mit dem Source-Anschluss der zehnten p-Kanal CMOS-Transistorstruktur P10 und der Drain-Anschluss der vierzehnten p-Kanal CMOS-Transistorstruktur P14 ist verbunden mit dem Source-Anschluss der fünfzehnten p-Kanal CMOS-Transistorstruktur P15, wodurch jeweils Stromquellen ausgebildet werden.

Gemäß Fig.2 ist dabei die aus der dritten p-Kanal CMOS-Transistorstruktur P3 und der vierten p-Kanal CMOS-Transistorstruktur P4 gebildete Stromquelle über den Drain-Anschluss der vierten p-Kanal CMOS-Transistorstruktur P4 mit den untereinander verbundenen Source-Anschlüssen der den Differenzverstärker der zweiten Verstärkerstufe B bildenden ersten p-Kanal CMOS-Transistorstruktur P1 und zweiten p-Kanal CMOS-Transistorstruktur P2 verbunden. Weiterhin ist die aus der elften p-Kanal CMOS-Transistorstruktur P11 und der zwölften p-Kanal CMOS-Transistorstruktur P12 gebildete Stromquelle über den Drain-Anschluss der zwölften p-Kanal CMOS-Transistorstruktur P12 mit den untereinander verbundenen Source-Anschlüssen der den Differenzverstärker der zweiten Eingangsstufe 4 der ersten Verstärkerstufe A bildenden siebten p-Kanal CMOS-Transistorstruktur P7 und zweiten n-Kanal FET-Transistorstruktur NFET2 verbunden.

Weiterhin ist gemäß Fig.2 die aus der neunten p-Kanal CMOS-Transistorstruktur P9 und der zehnten p-Kanal CMOS-Transistorstruktur P10 gebildete Stromquelle über den Drain-Anschluss der zehnten p-Kanal CMOS-Transistorstruktur P10 mit den untereinander verbundenen Source-Anschlüssen der den Differenzverstärker der ersten Eingangsstufe 3 der ersten Verstärkerstufe A bildenden fünften p-Kanal CMOS-Transistorstruktur P5 und sechsten p-Kanal CMOS-Transistorstruktur P6 verbunden.

Weiterhin ist der erste Ausgang des aus der ersten p-Kanal CMOS-Transistorstruktur P.1 und der zweiten p-Kanal CMOS-Transistorstruktur P2 gebildeten Differenzverstärkers der zweiten Verstärkerstufe B, der aus dem Drain-Anschluss der ersten p-Kanal CMOS-Transistorstruktur P1 gebildet wird, verbunden mit dem Drain-Anschluss der vierten n-Kanal CMOS-Transistorstruktur N4, mit dem Drain-Anschluss der zweiten n-Kanal CMOS-Transistorstruktur N2, dem Gate-Anschluss der vierten n-Kanal CMOS-Transistorstruktur N4 und dem Gate-Anschluss der ersten n-Kanal CMOS-Transistorstruktur N1, wodurch die vorgenannten Anschlüsse auch untereinander verbunden sind.

Der zweite Ausgang des aus der ersten p-Kanal CMOS-Transistorstruktur P1 und der zweiten p-Kanal CMOS-Transistorstruktur P2 gebildeten Differenzverstärkers der zweiten Verstärkerstufe B, der aus dem Drain-Anschluss der zweiten p-Kanal CMOS-Transistorstruktur P2 gebildet wird, ist dabei verbunden mit dem Drain-Anschluss der ersten n-Kanal CMOS-Transistorstruktur N1, mit dem Drain-Anschluss der dritten n-Kanal CMOS-Transistorstruktur N3, dem Gate-Anschluss der zweiten n-Kanal CMOS-Transistorstruktur N2 und dem Gate-Anschluss der dritten n-Kanal CMOS-Transistorstruktur N3, wodurch die vorgenannten Anschlüsse auch untereinander verbunden sind.

Die erste n-Kanal CMOS-Transistorstruktur N1, die zweite n-Kanal CMOS-Transistorstruktur N2, die dritte n-Kanal CMOS-Transistorstruktur N3 und die vierte n-Kanal CMOS-Transistorstruktur N4 sind dabei vorzugsweise unter Verwendung identischer Transistorstrukturen ausgebildet. Auf diese Weise stellen die zwei aus der vierten n-Kanal CMOS-Transistorstruktur N4 und der zweiten n-Kanal CMOS-Transistorstruktur M1 beziehungsweise aus der ersten n-Kanal CMOS-Transistorstruktur N1 und der dritten n-Kanal CMOS-Transistorstruktur N3 gebildeten Stromspiegel identische Stromspiegel dar, die erfindungsgemäß an den Ausgängen des Differenzverstärkers der zweiten Verstärkerstufe B eine symmetrische Last aus zwei über Kreuz geschalteten Stromspiegeln bilden.

Dabei ist der ersten Ausgang des aus der ersten p-Kanal CMOS-Transistorstruktur P1 und der zweiten p-Kanal CMOS-Transistorstruktur P2 gebildeten Differenzverstärkers der zweiten Verstärkerstufe B, der aus dem Drain-Anschluss der ersten p-Kanal CMOS-Transistorstruktur P1 gebildet wird, weiterhin verbunden mit dem Gate-Anschluss der achten p-Kanal CMOS-Transistorstruktur P8 und der zweite Ausgang des aus der ersten p-Kanal CMOS-Transistorstruktur P1 und der zweiten p-Kanal CMOS-Transistorstruktur P2 gebildeten Differenzverstärkers der zweiten Verstärkerstufe B, der aus dem Drain-Anschluss der zweiten p-Kanal CMOS-Transistorstruktur P2 gebildet wird ist weiterhin verbunden mit dem Gate-Anschluss der siebten p-Kanal CMOS-Transistorstruktur P7, wodurch die aus Fig.1 bekannten Verbindungen zwischen den Ausgängen der zweiten Verstärkerstufe B und den Eingängen der zweiten Eingangsstufe 4 der ersten Verstärkerstufe A gebildet werden.

Weiterhin ist gemäß Fig.2 der Drain-Anschluss der fünften p-Kanal CMOS-Transistorstruktur P5 verbunden mit dem Drain-Anschluss der sechsten n-Kanal CMOS-Transistorstruktur N6, mit dem Drain-Anschluss der siebten p-Kanal CMOS-Transistorstruktur P7, dem Gate-Anschluss der sechsten n-Kanal CMOS-Transistorstruktur N6 und dem Gate-Anschluss der fünften n-Kanal CMOS-Transistorstruktur N5, wodurch die vorgenannten. Anschlüsse auch untereinander verbunden sind. Weiterhin ist der Drain-Anschluss der achten p-Kanal CMOS-Transistorstruktur P8 verbunden mit dem Drain-Anschluss der sechsten p-Kanal CMOS-Transistorstruktur P6, dem Drain-Anschluss der fünften n-Kanal CMOS-Transistorstruktur N5, dem Gate-Anschluss der achtzehnten p-Kanal CMOS-Transistorstruktur P18 und dem Gate-Anschluss der zweiten n-Kanal FET-Transistorstruktur NFET2, wodurch die vorgenannten Anschlüsse auch untereinander verbunden sind.

Weiterhin ergibt sich aus diesen Verbindungen auch die aus Fig.1 bekannte Parallelschaltung der ersten Eingangsstufe 3 der ersten Verstärkerstufe A, gebildet aus der fünften p-Kanal CMOS-Transistorstruktur P5 und der sechsten p-Kanal CMOS-Transistorstruktur P6, mit der zweiten Eingangsstufe 4 der ersten Verstärkerstufe A, gebildet aus der siebten p-Kanal CMOS-Transistorstruktur P7 und der achten p-Kanal CMOS-Transistorstruktur P8. Erfindungsgemäß weist dabei die zweite Eingangsstufe 4 eine Steilheit auf, die einem Bruchteil der Steilheit der ersten Eingangsstufe 3, vorzugsweise ein Viertel der Steilheit beträgt. Der aus der sechsten n-Kanal CMOS-Transistorstruktur N6 und der fünften n-Kanal CMOS-Transistorstruktur N5 gebildete Stromspiegel stellt dabei die Last für die erste Verstärkerstufe A dar.

Die Funktionsweise der dritten Verstärkerstufe C, deren Detailschaltung die verbleibenden Bauteile der Schaltung Fig.2 umfasst und nachfolgend beschrieben wird, entspricht der Funktionsweise der aus der EP 0460 263 B1 bekannten zweiten Verstärkerstufe.

Gemäß Fig.2 ist die aus der vierzehnten p-Kanal CMOS-Transistorstruktur P14 und der fünfzehnten p-Kanal CMOS-Transistorstruktur P15 gebildete Stromquelle über den Drain-Anschluss der fünfzehnten p-Kanal CMOS-Transistorstruktur P15 mit den untereinander verbundenen Source-Anschlüssen der dreizehnten p-Kanal CMOS-Transistorstruktur P13 und achtzehnten p-Kanal CMOS-Transistorstruktur P18 sowie mit dem Gate-Anschluss der achten n-Kanal MOS-Transistorstruktur N8, dem Gate-Anschluss der siebten n-Kanal CMOS-Transistorstruktur N7, der ersten Anschlussklemme der Kapazität C0 und dem Drain-Anschluss der sechzehnten p-Kanal CMOS-Transistorstruktur P16 verbunden, woraus sich ergibt dass auch alle aufgeführten und mit der aus der vierzehnten p-Kanal CMOS-Transistorstruktur P14 und der fünfzehnten p-Kanal CMOS-Transistorstruktur P15 gebildeten Stromquelle verbundenen Anschlüsse und Klemmen auf diese Weise untereinander verbunden sind.

Weiterhin ist gemäß Fig.2 der Drain-Anschluss der achtzehnten p-Kanal CMOS-Transistorstruktur P18 verbunden mit dem Drain-Anschluss der siebten n-Kanal CMOS-Transistorstruktur N7 sowie mit dem Gate-Anschluss der zehnten n-Kanal CMOS-Transistorstruktur N10 und dem Gate-Anschluss der neunten n-Kanal CMOS-Transistorstruktur N9, demzufolge die Gate-Anschlüsse der zehnten n-Kanal CMOS-Transistorstruktur N10 und der neunten n-Kanal CMOS-Transistorstruktur N9 auch untereinander verbunden sind. Ebenfalls sind verbunden gemäß Fig.2 der Source-Anschluss der siebten n-Kanal CMOS-Transistorstruktur N7 mit dem Drain-Anschluss der zehnten n-Kanal CMOS-Transistorstruktur N10 sowie der der Source-Anschluss der achten n-Kanal CMOS-Transistorstruktur N8 mit dem Drain-Anschluss der neunten n-Kanal CMOS-Transistorstruktur N9.

Ebenfalls sind gemäß Fig.2 verbunden die Gate-Anschlüsse der sechzehnten p-Kanal CMOS-Transistorstruktur P16 und der siebzehnten p-Kanal CMOS-Transistorstruktur P17, die Gate-Anschlüsse der sechzehnten p-Kanal CMOS-Transistorstruktur P16 und der siebzehnten p-Kanal CMOS-Transistorstruktur P17 mit dem Drain-Anschluss der siebzehnten p-Kanal CMOS-Transistorstruktur P17 und dem Drain-Anschluss der achten n-Kanal CMOS-Transistorstruktur N8.

Weiterhin sind gemäß Fig.2 verbunden der Source-Anschluss der sechzehnten p-Kanal CMOS-Transistorstruktur P16 mit dem Drain-Anschluss der ersten p-Kanal FET-Transistorstruktur PFET1; der Gate-Anschluss der ersten p-Kanal FET-Transistorstruktur PFET1 mit den Gate-Anschlüssen der zweiten p-Kanal FET-Transistorstruktur PFET2 und der dritten p-Kanal FET-Transistorstruktur PFET3. Ebenfalls verbunden sind weiterhin der Gate-Anschluss der zweiten p-Kanal FET-Transistorstruktur PFET2 mit dem Drain-Anschluss der zweiten p-Kanal FET-Transistorstruktur PFET2 und dem Source-Anschluss der siebzehnten p-Kanal CMOS-Transistorstruktur P17, der Drain-Anschluss der dritten p-Kanal FET-Transistorstruktur PFET3 mit dem Drain-Anschluss der zweiten n-Kanal FET-Transistorstruktur NFET2 und der Ausgangsklemme out.

Ebenfalls untereinander verbunden sind gemäß Fig.2 die Source-Anschlüsse der ersten n-Kanal CMOS-Transistorstruktur N1, der zweiten n-Kanal CMOS-Transistorstruktur M1, der dritten n-Kanal CMOS-Transistorstruktur N3, der vierten n-Kanal CMOS-Transistorstruktur N4, der sechsten n-Kanal CMOS-Transistorstruktur N6, der fünften n-Kanal CMOS-Transistorstruktur N5, ersten n-Kanal FET-Transistorstruktur NFET1, der zweiten n-Kanal FET-Transistorstruktur NFET2 sowie die zweite Anschlussklemme der Kapazität C0, wobei diese Verbindung das Potential der unteren Betriebsspannung vss, beispielsweise Masse aufweist.

Bezeichnet durch die Bereiche B, A und C ist aus der Verstärkerschaltung gemäß Fig.2 die Zuordnung der beschriebenen Bauelementestrukturen zu den aus dem Blockschaltbild gemäß Fig.1 bekannten Verstärkerstufen, die zweite Verstärkerstufe B, die erste Verstärkerstufe A und die dritte Verstärkerstufe C zu entnehmen. Anzumerken ist, dass die Erweiterung einer zweistufigen Verstärkerschaltungsanordnung zu einer erfindungsgemäßen dreistufigen Verstärkerschaltungsanordnung mit jeder Art von zweistufigen Verstärkerschaltungsanordnungen in der beschriebenen Weise durchgeführt werden kann.

### Bezugszeichenliste

- A: Verstärker
- B: Verstärker
- C: Verstärker
- 1: Eingangsklemme
- 2: Eingangsklemme
- 3: Eingangsstufe
- 4: Eingangsstufe
- 8: Ausgangsklemme
- out: Ausgangsklemme
- pod: Eingangsklemme
- binsp: Eingangsklemme
- binspc: Eingangsklemme
- inm: Eingangsklemme
- inp: Eingangsklemme
- N1: n-Kanal CMOS-Transistorstruktur
- N2: n-Kanal CMOS-Transistorstruktur
- N3: n-Kanal CMOS-Transistorstruktur
- N4: n-Kanal CMOS-Transistorstruktur
- N5: n-Kanal CMOS-Transistorstruktur
- N6: n-Kanal CMOS-Transistorstruktur
- N7: n-Kanal CMOS-Transistorstruktur
- N8: n-Kanal CMOS-Transistorstruktur
- N9: n-Kanal CMOS-Transistorstruktur
- N10: n-Kanal CMOS-Transistorstruktur
- P1: p-Kanal CMOS-Transistorstruktur
- P2: p-Kanal CMOS-Transistorstruktur
- P3: p-Kanal CMOS-Transistorstruktur
- P4: p-Kanal CMOS-Transistorstruktur
- P5: p-Kanal CMOS-Transistorstruktur
- P6: p-Kanal CMOS-Transistorstruktur
- P7: p-Kanal CMOS-Transistorstruktur
- P8: p-Kanal CMOS-Transistorstruktur
- P9: p-Kanal CMOS-Transistorstruktur
- P10: p-Kanal CMOS-Transistorstruktur
- P11: p-Kanal CMOS-Transistorstruktur
- P12: p-Kanal CMOS-Transistorstruktur
- P13: p-Kanal CMOS-Transistorstruktur
- P14: p-Kanal CMOS-Transistorstruktur
- P15: p-Kanal CMOS-Transistorstruktur
- P16: p-Kanal CMOS-Transistorstruktur
- P17: p-Kanal CMOS-Transistorstruktur
- P18: p-Kanal CMOS-Transistorstruktur
- NFET1: n-Kanal FET-Transistorstruktur
- NFET2: n-Kanal FET-Transistorstruktur
- PFET1: p-Kanal FET-Transistorstruktur
- PFET2: p-Kanal FET-Transistorstruktur
- PFET3: p-Kanal FET-Transistorstruktur
- vdd: Spannungspotential
- vss: Spannungspotential
- C0: Kapazität
- C1: Kapazität
- C2: Kapazität
- C3: Kapazität

## Patentansprüche

1. Verstärkerschaltung,mit Offset-Reduktion und ausreichend hoher Bandbreite mit zwei an Eingangsklemmen (1, 2) parallel geschalteten Eingangsstufen (3, 4) eines ersten. Verstärkers (A), wobei die erste Eingangsstufe (3) mit den Eingangsklemmen direkt und die zweite Eingangsstufe (4) über einen zweiten Verstärker (B) angeschlossen ist, und wobei an den Ausgang des ersten Verstärkers (A) ein dritter Verstärker (C) geschaltet ist,
**dadurch gekennzeichnet, dass** der zweite Verstärker (B) eine symmetrische Last aufweist.

2. Verstärkerschaltung nach Anspruch 1,
**dadurch gekennzeichnet, dass** die symmetrische Last kreuzgekoppelt ist.

3. Verstärkerschaltung nach Anspruch 1 oder 2,
**dadurch gekennzeichnet, dass** die symmetrische Last zwei über Kreuz parallel geschaltete Stromspiegel aufweist.

4. Verstärkerschaltung nach Anspruch 1, 2 oder 3,
**dadurch gekennzeichnet, dass** der Ausgang des zweiten Verstärkers (B) an den Eingang der zweiten Eingangsstufe (4) des ersten Verstärkers (A) völlig symmetrisch angeschlossen ist.

5. Verstärkerschaltung nach einem der Ansprüche 1 bis 4,
**dadurch gekennzeichnet, dass** die Last ausnmalvier identischen Transistoren gebildet ist, wobein eine natürliche Zahl ist.

6. Verstärkerschaltung nach einem des Ansprüche 1 bis 5,
**dadurch gekennzeichnet, dass** die Verstärkerschaltung für Audio-Anwendungen eingesetzt wird.

7. Verstärkerschaltung nach einem der Ansprüche 1 bis 6,
**dadurch gekennzeichnet, dass** die zweite Eingangsstufe (4) eine Steilheit aufweist, die ein Bruchteil der Steilheit der ersten Eingangsstufe (3) hat.

8. Verstärkerschaltung nach Anspruch 7,
**dadurch gekennzeichnet, dass** der Bruchteil etwa 1/4 ist.
